(19) Europäisches Patentamt

European Patent Office

Office européen des brevets

(11) Veröffentlichungsnummer: **0 381 729 B1**

(12) **EUROPÄISCHE PATENTSCHRIFT**

(45) Veröffentlichungstag der Patentschrift: **05.04.95**

(21) Anmeldenummer: **89908424.8**

(22) Anmeldetag: **26.07.89**

(86) Internationale Anmeldenummer:
**PCT/EP89/00880**

(87) Internationale Veröffentlichungsnummer:
**WO 90/01517 (22.02.90 90/05)**

(51) Int. Cl.⁶: **C08K 5/41**, C08L 61/20

(54) **SÄUREHÄRTBARE BINDEMITTELSYSTEME MIT 1,2-DISULFONEN.**

(30) Priorität: **03.08.88 DE 3826363**

(43) Veröffentlichungstag der Anmeldung:
**16.08.90 Patentblatt 90/33**

(45) Bekanntmachung des Hinweises auf die
Patenterteilung:
**05.04.95 Patentblatt 95/14**

(84) Benannte Vertragsstaaten:
**DE FR GB IT**

(56) Entgegenhaltungen:
**DE-A- 3 630 693**

**CHEMICAL ABSTRACTS, Band 99, Nr. 18, 31. Oktober 1983 (Columbus, Ohio, US), M. TSU-NOOKA et al.: "Photocrosslinking of Poly(2,3-Epoxypropyl Methacrylate) Films with Organic Sulfur Compounds", seite 38\* Zusammenfassung Nr. 140979v, & Makromol. Chem. Rapid Commun. 1983, 4(8), 539-41\***

**CHEMICAL ABSTRACTS, Band 102, Nr. 22, 3. Juni 1985 (Colombus, Ohio, US), seite 38\***

Zusammenfassung Nr. 186029u. & JP, A, 59197422 (Arakawa Chemical Industries) 9, November 1984\*

Makromol. Chem. Rapid Commun. 4, 539 - 541, (1983)

(73) Patentinhaber: **CIBA-GEIGY AG**
**Klybeckstrasse 141**
**CH-4002 Basel (CH)**

(72) Erfinder: **BARTMANN, Ekkehard**
**Dieburger Weg 12a**
**D-6106 Erzhausen (DE)**
Erfinder: **OHNGEMACH, Jörg**
**Taubenstr. 6**
**D-6107 Reinheim (DE)**

EP 0 381 729 B1

**Beschreibung**

Die Erfindung betrifft säurehärtbare Bindemittelsysteme, die 1,2-Disulfone als thermisch und photochemisch aktivierbare Säurekatalysatoren enthalten.

Ein großer Teil der Bindemittelsysteme in der Lack- und Beschichtungstechnik beruht auf hitzehärtenden Materialien, in denen durch Polykondensation eine Vernetzung und damit die Aushärtung erfolgt. Zur Polykondensation befähigte Basismaterialien sind hierbei normalerweise Aminoplast-Kunstharze, deren thermische Aushärtung durch Säuren, insbesondere organische Sulfonsäuren, katalysiert wird. Typischer und sehr häufig verwendeter Säurekatalysator ist p-Toluolsulfonsäure (PTS). Säurehärtbare Systeme haben aber den Nachteil, daß sie, wenn sie mit dem Säurekatalysator versetzt sind, nur eine begrenzte Lagerfähigkeit besitzen und alsbald gelieren, wenn sie nicht innerhalb kürzerer Zeit verarbeitet werden. Sulfonsäurekatalysatoren in "geblockter" Form, etwa als Aminosalze oder Oximester von Hydroxamsäuren, ermöglichen eine bessere Lagerstabilität. Aus diesen geblockten Formen können die katalytisch aktiven Säuren durch Erhitzen auf höhere Temperaturen freigesetzt werden. Die Härtung der entsprechenden Systeme erfordert hierdurch jedoch einen höheren Energieaufwand.

In der Lack- und Beschichtungstechnik hat neben der thermischen Härtung auch die photochemisch induzierte Härtung große Bedeutung erlangt, wobei spezielle strahlungshärtbare Zusammensetzungen zur Anwendung gelangen, die Fotoaktivatoren bzw. Fotoinitiatoren zur Umsetzung der Strahlungsenergie enthalten. Die Strahlungshärtung zeichnet sich insbesondere durch hohe Geschwindigkeit und geringen Energiebedarf aus. Die für die praktische Anwendung wichtigste Fotopolymerisationsreaktion ist die radikalische Polyaddition von ethylenischen Doppelbindungen. Entsprechende strahlungshärtbare Systeme basieren daher auf Materialien, die radikalisch polymerisierbare bzw. vernetzbare ethylenische Doppelbindungen enthalten, und radikalbildenden Fotoinitiatoren.

Thermisch säurekatalysiert härtende Systeme sind im Prinzip ebenfalls der Strahlungshärtung zugänglich, wenn statt der üblichen Säurekatalysatoren photochemisch aktivierbare latente Säurekatalysatoren eingesetzt werden. Durch Strahlungseinwirkung muß aus diesen die katalytisch wirkende Säure freigesetzt werden können, die die eigentliche Härtung, zweckmäßiger Weise gefördert durch zusätzliche Zufuhr von thermischer Energie, bewirkt. Für diesen Zweck schon länger bekannte Verbindungen vom Typ der Halogen- bzw. Sulfonyloxyacetophenone haben den Nachteil, korrosiv zu wirken, die gehärteten Schichten zu vergilben oder anderweitig nachteilig zu beeinflussen; weiterhin sind mit ihnen Stabilitäts- und Kompatibilitätsprobleme verbunden.

Jüngere Bemühungen, die bekannten Nachteile der säurekatalysiert thermisch härtenden Systeme zu vermindern und in ihnen die Vorteile der photochemischen Aktivierung mittels UV-Strahlung zu nutzen, schlagen sich beispielsweise in EP 192 967 nieder. Dort werden Sulfonyl-Derivate von aromatisch-aliphatischen Ketonen insbesondere α-Sulfonylacetophenon-Verbindungen offenbart, die als photochemisch aktivierbare latente Säurekatalysatoren verwendet werden können. Diesen Verbindungen werden gegenüber den vorbekannten UV-Säurekatalysatoren günstigere Anwendungseigenschaften, insbesondere hinsichtlich Beeinflussung der gehärteten Schicht und Lagerstabilität des Bindemittelsystems, zugeschrieben. Weiterhin können diese Verbindungen als radikalerzeugende Fotoinitiatoren für radikalisch polymerisierbare Bindemittelsysteme sowie für Hybrid-Bindemittelsysteme auf Basis von radikalisch und säurehärtenden Bestandteilen verwendet werden.

Die aus EP 192 967 bekannten Verbindungen haben aber den Nachteil, daß sie aufgrund besonderer thermischer Stabilität nicht durch Hitzeeinwirkung allein aktivierbar sind. Sie sind daher, was ihren Wert für die praktische Anwendung schmälert, nur begrenzt einsatzfähig, da sie in jedem Falle eine photochemische Aktivierung erforderlich machen. Entsprechende Bindemittelsysteme und Härtungsprozesse müssen für die photochemische Härtung geeignet bzw. ausgelegt sein.

Aus dem Stand der Technik waren also keine Substanzen bekannt, die sich für die rein thermische und gleichzeitig auch für die photochemische Härtung von säurehärtbaren Bindemittelsystemen eignen.

Ziel der Erfindung war es daher, Verbindungen aufzufinden, die sich als latente Säurekatalysatoren für säurehärtbare Bindemittelsysteme eignen und die sowohl rein thermisch als auch kombiniert thermisch/photochemisch aktivierbar sind.

Überraschend wurde nun gefunden, dass 1,2-Disulfon-Verbindungen der Formel I

$$R^1\text{-}SO_2\text{-}SO_2\text{-}R^2 \qquad I$$

worin $R^1$ und $R^2$ gleich oder verschieden sein können und Alkyl, Cycloalkyl, Aryl, Aralkyl oder Heteroaryl mit bis zu 12 C-Atomen, gegebenenfalls ein- oder mehrfach substituiert mit Halogen, Cyano, Nitro, Alkyl, Alkoxy, Alkylthio, Mono- oder Bisalkylamino, Alkanoyl, Acyloxy, Acylamido, Alkoxycarbonyl, Alkylaminocar-

2

bonyl, Alkylsulfoxy, Alkylsulfonyl, Aryloxy, Arylthio, Arylsulfoxy, Arylsulfonyl mit jeweils bis zu 6 C-Atomen, bedeuten, als thermisch oder durch kombiniertes Bestrahlen und Erhitzen aktivierbare latente Säurekatalysatoren in Bindemittelsystemen, die mindestens eine säurekatalysiert polykondensationsfähige Komponente enthalten, vorzüglich geeignet sind. Mit Hilfe dieser Verbindungen lassen sich säurehärtbare Bindemittelsysteme sowohl thermisch als auch kombiniert thermisch und photochemisch aushärten. Sie eignen sich hierbei prinzipiell für alle Bindemittelsysteme, die mindestens eine säurehärtbare Komponente enthalten. Dementsprechend eignen sie sich auch für Hybrid-Bindemittelsysteme, die darüberhinaus, noch andere Komponenten, insbesondere radikalisch polymerisierbare Komponenten, enthalten. Ein weiterer Vorzug der 1,2-Disulfon-Verbindungen ist, dass sie in sehr einfacher Weise und damit äusserst wirtschaftlich herstellbar sind.

Gegenstand der Erfindung ist daher auch die Verwendung von Verbindungen der Formel I als thermisch und kombiniert thermisch und photochemisch aktivierbare latente Säurekatalysatoren in Bindemitteln, enthaltend mindestens eine säurehärtbare Komponente.

Gegenstand der Erfindung ist weiterhin ein Verfahren zur Härtung von Bindemittelsystemen die mindestens eine säurekatalysiert polykondensationsfähige Komponente enthalten, wobei man diesen eine wirksame Menge mindestens einer Verbindung der Formel I zusetzt dadurch gekennzeichnet, daß man die Härtung durch Erhitzen oder durch kombiniertes Bestrahlen und Erhitzen vornimmt.

Gegenstand der Erfindung sind weiterhin säurehärtbare Bindemittelsysteme, insbesondere auch solche, die zusätzlich radikalisch polymerisierbare Komponenten enthalten, die mindestens eine Verbindung der Formel I enthalten.

Die erfindungsgemäß einzusetzenden 1,2-Disulfonverbindungen der Formel I sind zum großen Teil an sich bekannt. Von einigen 1,2-Diaryldisulfonen ist zwar auch bekannt, daß sie strahlungsreaktiv sind. So ist beispielsweise aus Bull. Chem. Soc. Jap. 45, 2906 (1972) (CA 78: 15196c) bekannt, daß Diaryldisulfone photoreaktiv sind und unter Strahlungseinwirkung in Radikale zerfallen. Nach JP 58-83844 (CA 101: 63684a) werden solche Verbindungen als Radikalerzeuger in lichtempfindlichen Zusammensetzungen für photolithographische Zwecke eingesetzt. In den dort beschriebenen Systemen dienen sie jedoch lediglich zur Auslösung einer Farbreaktion um einen visuellen Kontrast zwischen bestrahlten und nicht bestrahlten Schichtbereichen zu erzeugen. Für die Fotostrukturierungen der Schicht müssen in jedem Fall weitere strahlungsreaktive Verbindungen vorhanden sein. Gemäß Makromol. Chem., Rapid Commun. 4, 539 (1983) (CA 99: 140979v) und JP 59-197422 (CA 102: 186029u) können Diaryldisulfone als Strahlungsvernetzer für Epoxy-funktionalisierte Acrylatpolymere verwendet werden, wobei ein Säuremechanismus angenommen wird. Diesem Stand der Technik konnte jedoch nicht entnommen werden, daß sich diese Verbindungen und darüberhinaus 1,2-Disulfone von weitaus breiterer struktureller Vielfalt vorzüglich als sowohl thermisch wie auch kombiniert thermisch/photochemisch aktivierbare latente Säurekatalysatoren für säurehärtbare Bindemittelsysteme eignen. Insbesondere war die thermische Aktivierbarkeit nicht zu erwarten, da die Verbindungen der Formel I überwiegend sehr hoch liegende Schmelz- bzw. Zersetzungspunkte aufweisen.

In Formel I können die Substituenten $R^1$ und $R^2$ gleich oder verschieden sein und Alkyl, Cycloalkyl, Aryl, Aralkyl oder Heteroalkyl mit bis zu 12 C-Atomen, gegebenenfalls ein- oder mehrfach substituiert mit Halogen, Cyano, Nitro, Alkyl, Alkoxy, Alkylthio, Mono- oder Bisalkylamino, Alkanoyl, Alkanoyloxy, Alkanoylamido, Alkoxycarbonyl, Alkylaminocarbonyl, Alkylsulfoxy, Alkylsulfonyl, Aryloxy, Arylthio, Arylsulfoxy, Arylsulfonyl mit jeweils bis zu 6 C-Atomen, bedeuten.

Bevorzugte Reste $R^1$ und $R^2$ sind beispielsweise Methyl, Ethyl, n- und i-Propyl, Cyclohexyl, Phenyl, Benzyl, Pyridyl, Naphthyl, Tolyl, Anisyl, 2,4,6-Trimethylphenyl, 4-Isopropylphenyl, Chlor-, Brom- und Nitrophenyl.

Die Verbindungen der Formel I können im Prinzip alle nach Verfahren hergestellt werden, wie sie für 1,2-Disulfone in der Literatur bereits beschrieben sind. Gemäß der deutschen Patentanmeldung P 38 04 316 hat sich als ein Syntheseverfahren der Wahl erwiesen, 1,2-Disulfonylhydrazine, die leicht durch Umsetzung von Hydrazin mit Sulfonsäurechloriden zugänglich sind, mit konzentrierter Salpetersäure als Oxidationsmittel zu den 1,2-Disulfonen der Formel I zu oxidieren. Dieser Syntheseweg ist sehr einfach, erbringt gute Ausbeuten und ermöglicht den Zugang zu praktisch beliebigen Substituentenkombinationen von $R^1$ und $R^2$.

Bevorzugt werden symmetrische und insbesondere unsymmetrische 1,2-Disulfon-Verbindungen der Formel I eingesetzt, bei denen $R^1$ und $R^2$ Phenyl, mit Methyl, Methoxy oder Isopropyl substituiertes Phenyl, Naphthyl oder $C_{1-3}$-Alkyl darstellen. Als Beispiele für solche Verbindungen sind besonders hervorzuheben 1,2-Diphenyldisulfon, 1-(4-Methylphenyl)-2-phenyldisulfon, 1-(4-Methoxyphenyl)-2-phenyldisulfon, 1-(4-Isopropylphenyl)-2-phenyldisulfon, 1-(4-Isopropylphenyl)-2-(4-methylphenyl)disulfon, 1-(1-Naphthyl)-2-phenyldisulfon, 1-(4-Methylphenyl)-2-methyldisulfon,1,2-Di-n-propyldisulfon, 1-(4-Methoxyphenyl)-2-n-propyldisulfon.

3

Erfindungsgemäß können die Verbindungen der Formel I als thermisch und kombiniert thermisch/photochemisch aktivierbare latente Säurekatalysatoren für säurehärtbare Bindemittelsystems verwendet werden. Die thermische Aktivierung erfolgt hierbei in dem für säurekatalysiert wärmehärtende Systeme üblichen Temperaturrahmen. Dieser liegt etwa zwischen 80 und 150 °C, vorzugsweise zwischen 100 und 120 °C. Die photochemische Aktivierung kann je nach Natur der Substituenten $R^1$ und $R^2$ in einem Wellenlängenbereich von etwa 200-450 nm erfolgen. Verbindungen der Formel I, in denen die Substituenten $R^1$ und $R^2$ Phenyl oder niedrig substituiertes Phenyl darstellen, sind besonders effektiv vornehmlich im tiefen bis mittleren UV-Bereich, etwa zwischen 200 und 300 nm. Durch den Zusatz von in längerwelligen Bereichen absorbierenden Cosensibilisatoren bekannter Art, etwa aromatischen Ketonen, kann, falls erforderlich oder erwünscht, die Empfindlichkeit im nahen UV-Bereich gesteigert werden. Die Verbindungen der Formel I sind sowohl bei thermischer als auch kombiniert thermisch/photochemischer Aktivierung ausreichend wirksam, wenn sie in den Bindemittelsystemen in einem Anteil von 0,1-20 Gew.% vorliegen. Bevorzugt liegt ihr Anteil zwischen 1 und 10 Gew.%; besonders zweckmäßig und wirtschaftlich ist ihr Einsatz in einem Anteil von etwa 2 Gew.%.

Säurehärtbare Bindemittelsysteme, die den erfindungsgemäßen Einsatzbereich der Verbindungen der Formel I darstellen, sind alle diejenigen Systeme, die mindestens eine säurekatalysiert polykondensationsfähige Komponente enthalten. Es sind dies überwiegend Kunstharz-Materialien auf Melamin- oder Harnstoffbasis, die auch in vielfältiger Weise modifiziert sein können. Dem Fachmann sind diese Materialien geläufig; sie werden in großen Mengen und für die unterschiedlichsten Einsatzzwecke in ihren Materialeigenschaften modifiziert industriell hergestellt. Ein typisches Beispiel für ein Melamin-Basismaterial ist etwa Hexamethoxymethylmelamin. Darüberhinaus können die säurehärtbaren Bindemittelsysteme beliebige weitere Komponenten in unterschiedlichen Anteilen enthalten, wie sie in der Technologie der Aminoplast-Kunststoffe üblich sind, beispielsweise Alkyd-, Phenol-, Polyester-, Acryl- und Polyvinylharze bzw. deren Gemische.

Die Verbindungen der Formel I eignen sich als Härtungskatalysatoren insbesondere auch für Hybrid-Bindemittelsysteme, die säurekatalysiert polykondensationsfähige sowie radikalisch polymerisierbare Anteile enthalten. Die Disulfone der Formel I können hierbei erfindungsgemäß rein photochemisch und zweckmäßigerweise kombiniert photochemisch-thermisch aktiviert werden, wobei sie gleichermaßen als Radikal- und Säuregeneratoren fungieren und somit praktisch simultan die Härtung der unterschiedlichen Hybridsystemkomponenten bewirken. Als säurehärtbare Komponenten für derartige Hybrid-Systeme kommen alle oben bereits angeführten Materialien in Frage. Als radikalisch polymerisierbare Komponenten sind praktisch alle Materialien, die olefinisch ungesättigte Doppelbindungen aufweisen, geeignet. Es können dies insbesondere Monomere, Oligomere und Polymere mit jeweils zumindest einer oder zweckmäßigerweise mit mehreren ungesättigten Funktionen vom Acrylat- oder Vinyl-Typ sein. Entsprechende Materialien sind dem Fachmann in großer Fülle aus dem Gebiet der radikalischen Polymerisation und insbesondere aus der Technologie der Strahlungshärtung mit Hilfe radikalbildender Fotoinitiatoren bekannt. In derartigen Hybrid-Bindemittelsystemen kann der Anteil an säurehärtbaren und radikalisch polymerisierbaren Komponenten in breiten Bereichen, etwa jeweils zwischen 10 und 90 Gew.%, variiert werden.

Die mit den Verbindungen der Formel I als Katalysatoren härtbaren Bindemittelsysteme, ob auf rein säurehärtbarer oder auf Hybridbasis, können in ihren qualitativen wie quantitativen Zusammensetzungen in weiten Bereichen variiert werden und sie können insbesondere auch weitere Bestandteile und Zusätze enthalten. Zweckmäßigerweise sollte hierbei der Anteil an reaktiven Komponenten 10 Gew.% nicht unterschreiten. Als weitere Bestandteile und Zusätze in den für den jeweiligen Zweck angebrachten und üblichen Mengen können anorganische und organische Pigmente, Farbstoffe, Füllstoffe, Verlaufsmittel, oberflächenaktive Mittel, Lichtstabilisatoren und Antioxydantien, Thixotropiemittel, Mattierungsmittel, Weichmacher, weitere Bindemittel und Harze, spektrale Sensibilisatoren und Coinitiatoren, weitere thermo- bzw. photoreaktive Radikalstarter sowie Kationen- oder säurebildende Katalysatoren enthalten sein.

Die genannten Bindemittelsysteme können mit den Verbindungen der Formel I erfindungsgemäß auf verschiedene Weise gehärtet werden, nämlich rein thermisch und kombiniert photochemisch-thermisch. Bei rein thermischer Härtung sind in bezug auf die erzielbaren Schichthärten die Disulfone der Formel I praktisch gleichwertig mit den bekannten thermischen Säurekatalysatoren wie p-Toluolsulfonsäure und deren Derivate. Gegenüber diesen haben sie aber die zusätzliche vorteilhafte Eigenschaft, auch photochemisch aktivierbar zu sein. Weiterhin sind sie den bekannten thermischen Säurekatalysatoren in bezug auf die Lagerstabilität der damit versetzten Bindemittelsysteme erheblich überlegen. Auch zeigen sie keine Neigung, das gehärte Endprodukt negativ zu beeinflussen, insbesondere zu vergilben.

Bei kombinierter photochemischer Aktivierung mit den Disulfonen der Formel I ist es zweckmäßig, die Aus- bzw. Nachhärtung durch gleichzeitige oder anschließende Wärmebehandlung zu fördern, wobei die Wärmebehandlung in der Weise wie bei rein thermischer Härtung vorgenommen wird. Hierbei sind die

4

erzielbaren Schichthärten gleichwertig mit denen die bei rein thermischer Härtung mit den bekannten Säurekatalysatoren zu erhalten sind. Die erzielbaren Schichthärten sind ebenfalls gleichwertig mit denen, die mit den aus EP 192 967 bekannten $\alpha$-Sulfonylacetophenonenzu erzielen sind. Die $\alpha$-Sulfonylacetophenone können jedoch als nur photochemisch aktivierbare latente Säurekatalysatoren in rein thermischen Härtungsprozessen nicht angewendet werden.

Durch die erfindungsgemäß als thermisch und kombiniert thermisch/photochemisch aktivierbare latente Säurekatalysatoren verwendbaren 1,2-Disulfone der Formel I wird ganz allgemein die Palette der Härtungskatalysatoren für Bindemittelsystems auf Basis säurekatalysiert polykondensierbarer Komponenten bereichert. Gegenüber üblichen Härtungskatalysatoren haben die Verbindungen der Formel I den besonderen Vorzug universeller, nämlich in rein thermischen wie auch in photochemischen Prozessen gleichermaßen gut einsetzbar zu sein. Ihre sehr einfache und daher wirtschaftliche Zugänglichkeit und ihre vorzüglichen anwendungstechnischen Eigenschaften machen sie darüberhinaus für den praktischen Einsatz besonders wertvoll.

Beispiele

A. Allgemeine Vorschrift zur Herstellung von 1,2-Disulfonen der Formel $R^1\text{-}SO_2\text{-}SO_2\text{-}R^2$    (I)

Zur entsprechenden 1,2-Disulfonylhydrazinverbindung wird unter Rühren und Eiskühlung konzentrierte Salpetersäure (Dichte 1,4) getropft. Die Reaktion setzt nach einigen Minuten unter Stickstoffentwicklung ein. Nach Abklingen der Reaktion wird noch etwa 1 Stunde bei 0 °C gerührt, der ausgefallene Niederschlag abgetrennt und zur Reinigung umkristallisiert. B. Hergestellte Verbindungen

| Nr. | $R^1$ | $R^2$ | Umkristalli- lisiert aus | Schmelz- punkt (°C) |
|---|---|---|---|---|
| 1 | Phenyl | Phenyl | Ethanol | 192 |
| 2 | " | 4-Methylphenyl | Methanol | 177 |
| 3 | " | 4-Methoxyphenyl | Aceton | 153 |
| 4 | " | 2-Naphthyl | Methyl-t-Butyl- ether | 182 |
| 5 | " | Benzyl | Methyl-t-Butyl- ether/Aceton | 186 |
| 6* | " | 2-Nitro-3,5- dimethoxyphenyl | Aceton | 186 |
| 7 | " | 2,4,6-Trimethyl- phenyl | Toluol | 154 |
| 8 | " | 4-i-Propylphenyl | Eisessig | 92 |
| 9 | " | 4-Chlorphenyl | Toluol | 181 |
| 10 | " | 4-Bromphenyl | Aceton | 198 |
| 11 | 4-Methylphenyl | 4-Methylphenyl | Aceton/Ether | 222 |
| 12 | " | 4-Chorphenyl | Toluol | 206 |
| 13 | " | Benzyl | Methanol | 126 |
| 14 | " | 4-t-Butylphenyl | Eisessig | 162 |
| 15 | 4-Methylphenyl | 2-Naphthyl | Methyl-t-Butyl- ether/Dichlor- methan | 186 |
| 16 | " | 4-Methoxyphenyl | Aceton | 173 |
| 17* | " | 2-Nitro-3,5- dimethoxyphenyl | Aceton | 182 |
| 18 | " | Methyl | Methyl-t-Butyl- ether | 109 |
| 19 | " | 1-Naphthyl | Aceton | 201 |
| 20 | 1-Naphthyl | 1-Naphthyl | Aceton/DMF | 183 (Zer- setzung) |
| 21 | 2-Naphthyl | 2-Naphthyl | THF | 226 (Zer- setzung) |
| 22 | 4-Methoxy- phenyl | 4-Methoxyphenyl | Aceton | 194 (Zer- setzung) |

| 23 | 4-Nitrophenyl | 4-Nitrophenyl | THF | 224 (Zer-setzung) |
|---|---|---|---|---|
| 24 | 2-Methylphenyl | 2-Methylphenyl | Toluol | 160 |
| 25 | Benzyl | Benzyl | Eisessig | 183 (Zer-setzung) |
| 26 | Benzyl | n-Propyl | Dichlormethan/n-Pentan | 100 |
| 27 | n-Propyl | n-Propyl | (Wasser)** | 53 |
| 28 | n-Propyl | 4-Nitrophenyl | Methyl-t-Butyl-ether | 111 |
| 29 | n-Propyl | 4-Methoxyphenyl | Petrolether | 83 |
| 30 | Phenyl | n-Propyl | Methyl-t-Butyl-ether | 138 |
| 31 | " | 4-t-Butylphenyl | (Wasser)** | 128 |
| 32 | 4-Methyl-phenyl | n-Propyl | (Wasser)** | 86 |
| 33 | 4-i-Propyl-phenyl | Methyl | - | (Öl) |
| 34 | 4-t-Butyl-phenyl | n-Propyl | Ether/Petrol-ether | 110 |
| 35 | 1-Naphthyl | Methyl | Toluol | 157 |
| 36 | 1-Naphthyl | n-Propyl | (Wasser)** | 116 |
| 37 | 2-Naphthyl | Methyl | (Wasser)** | 146 |
| 38 | 2-Naphthyl | n-Propyl | Ether/Petrolether | 67 |
| 39 | 4-Acetylamido-phenyl | n-Propyl | Eisessig | 189 |
| 40 | " | Phenyl | " | 208 |
| 41 | " | 4-Methylphenyl | " | 201 |
| 42 | " | 4-Methoxyphenyl | " | 204 |
| 43 | " | 4-Nitrophenyl | " | 198 (Zer-setzung) |
| 44 | 4-Phthalimido-phenyl | n-Propyl | " | 196 |
| 45 | " | Phenyl | Dichlormethan/Cyclohexan | 210 |
| 46 | " | 4-Methylphenyl | Eisessig | 214 |
| 47 | " | 4-Methoxyphenyl | " | 162 |

| 48 | 4-(1,2-Di-methylmalein-imido)phenyl | n-Propyl | Methyl-t-butylether | 143 |
| 49 | " | Phenyl | Dichlormethan | 222 |
| 50 | " | 4-Methylphenyl | Dichlormethan/ Petrolether | 235 |
| 51 | " | 4-Methoxyphenyl | Eisessig | 162 |
| 52 | 4-Nitrophenyl | n-Propyl | Ether | 104 |

\*    Die Einführung der $NO_2$-Gruppe erfolgt hier während der Salpetersäure-Oxidation

\*\*    Kristallisiert bereits bei Zugabe von Wasser in ausreichender Reinheit aus

C. Anwendungstechnische Vergleichsversuche

In Proben eines säurehärtbaren Lacksystems, bestehend aus

10 Gewichtsteilen Hexamethoxymethylmelamin (Cymel 303, Fa. Dyno Cyanamid)

90 Gewichtsteilen eines carboxylierten Polyacrylat-Harzes (Luprenal LR 8491, Fa. BASF)

wurden die zu testenden Verbindungen der Formel I (erfindungsgemäß) bzw. die Vergleichssubstanzen nach dem Stand der Technik in Form 10%iger Lösungen in n-Butanol gleichmäßig eingerührt.

Die gebrauchsfertigen Lackproben wurden dann auf Glasplatten (10 x 10 cm) in einer Schichtdicke von 80 µm appliziert und zur Entfernung des Lösungsmittels abgelüftet.

Als Vergleichssubstanzen dienten:

p-Toluolsulfonsäure-Monohydrat[+)] (PTS)

2-Phenylsulfonyl-2-methylpropiophenon[++)] (V1)

2-(4-Methylsulfonyl)-2-methylpropiophenon[++)] (V2)

2-(4-Methylsulfonyl)-2-methyl-(4'-methylthio)-propiophenon[++)] (V3)

[+)]    gängiger thermischer Säurekatalysator
[++)]    Säurekatalysatoren nach EP 192 967

Versuch 1: Thermische Härtung

Die beschichteten Platten wurden 30 Minuten bei 120 °C ausgehärtet. Nach dem Abkühlen wurde als Maß für das Härtungsergehnis die Pendelhärte nach König (DIN 53157) bestimmt. Tabelle 1 zeigt das Ergebnis.

8

Tabelle 1

| Substanz | /Gehalt | Pendelhärte (Sekunden) |
|----------|---------|------------------------|
| Nr. 8 | /2 Gew.% | 154 |
| PTS | /2 Gew.% | 171 |
| V1 | /2 Gew.% | 116 |
| V2 | /2 Gew.% | 137 |
| V3 | /2 Gew.% | 113 |
| keine | | 145 |

Es zeigt sich, daß die erfindungsgemäße Substanz eine gute, nur von PTS übertroffene Härtung bewirkt. Demgegenüber sind die Vergleichssubstanzen V1-V3 nicht thermisch aktivierbar. Ihre Anwesenheit setzt eher die Schichthärte gegenüber dem nichtkatalysierten System herab.

Versuch 2: Kombiniert photochemisch-thermische Härtung

Die beschichteten Platten wurden zunächst mit Hilfe eines Transportbandes mit einer Geschwindigkeit von 5 m/min in einem Abstand von 10 cm unter einer UV-Mitteldrucklampe einer Leistung von 80 W/cm vorbeigeführt. Nach der Bestrahlung waren die Oberflächen noch klebrig. Die thermische Nachhärtung erfolgte dann für 30 Minuten bei 120 °C. Tabelle 2 zeigt das Härtungsergehnis (Pendelhärte nach König).

Tabelle 2

| Substanz | /Gehalt | Pendelhärte (Sekunden) |
|----------|---------|------------------------|
| Nr. 3 | /2 Gew.% | 158 |
| Nr. 4 | /2 Gew.% | 148 |
| Nr. 8 | /2 Gew.% | 170 |
| Nr. 14 | /2 Gew.% | 167 |
| PTS | /2 Gew.% | 165 |
| V1 | /2 Gew.% | 172 |
| V2 | /2 Gew.% | 167 |
| V3 | /2 Gew.% | 148 |

Mit den erfindungsgemäßen Substanzen werden vorzügliche Schichthärten erreicht, die auch von den Vergleichssubstanzen praktisch nicht übertroffen werden.

**Patentansprüche**

**1.** Verwendung von Verbindungen der Formel I

$$R^1\text{-}SO_2\text{-}SO_2\text{-}R^2 \qquad (I)$$

worin $R^1$ und $R^2$ gleich oder verschieden sein können und Alkyl, Cycloalkyl, Aryl, Aralkyl oder Heteroaryl mit bis zu 12 C-Atomen, gegebenenfalls ein- oder mehrfach substituiert mit Halogen, Cyano, Nitro, Alkyl, Alkoxy, Alkylthio, Mono- oder Bisalkylamino, Alkanoyl, Acyloxy, Acylamido, Alkoxycarbonyl, Alkylaminocarbonyl, Alkylsulfoxy, Alkylsulfonyl, Aryloxy, Arylthio, Arylsulfoxy, Arylsulfonyl mit jeweils bis zu 6 C-Atomen, bedeuten, als thermisch oder durch kombiniertes Bestrahlen und Erhitzen aktivierbare latente Säurekatalysatoren in Bindemittelsystemen, die mindestens eine säurekatalysiert polykondensationsfähige Komponente enthalten.

**2.** Verfahren zur Härtung von Bindemittelsystemen, die mindestens eine säurekatalysiert polykondensationsfähige Komponente enthalten, dadurch gekennzeichnet, dass man diesen eine wirksame Menge mindestens einer Verbindung der Formel I zusetzt, dadurch gekennzeichnet, dass man die Härtung durch Erhitzen oder durch kombiniertes Bestrahlen und Erhitzen vornimmt.

3. Verfahren nach Anspruch 2, dadurch gekennzeichnet, dass man 0,1 bis 20 Gew.%, vorzugsweise 1 bis 10 Gew.%, an Verbindung(en) der Formel I zusetzt.

4. Bindemittelsysteme, die mindestens eine säurekatalysiert polykondensationsfähige Komponente enthalten, dadurch gekennzeichnet, dass sie mindestens eine Verbindung der Formel I enthalten.

5. Bindemittelsysteme nach Anspruch 4, dadurch gekennzeichnet, dass sie zusätzlich radikalisch polymerisierbare Komponenten enthalten.

6. Bindemittelsysteme nach Anspruch 4 oder 5, dadurch gekennzeichnet, dass sie 0,1 bis 20 Gew.%, vorzugsweise 1 bis 10 Gew.%, an Verbindung(en) der Formel I enthalten.

**Claims**

1. The use of compounds of the formula I

$R^1$-$SO_2$-$SO_2$-$R^2$    (I)

in which $R^1$ and $R^2$ may be identical or different and are alkyl, cycloalkyl, aryl, aralkyl or heteroaryl having up to 12 carbon atoms and unsubstituted or substituted one or more times by halogen, cyano, nitro, alkyl, alkoxy, alkylthio, mono- or bisalkylamino, alkanoyl, acyloxy, acylamido, alkoxycarbonyl, alkylaminocarbonyl, alkylsulfoxy, alkylsulfonyl, aryloxy, arylthio, arylsulfoxy or arylsulfonyl having in each case up to 6 carbon atoms, as latent acid catalysts which can be activated thermally or by combined irradiation and heating, in binder systems which contain at least one component which is capable of undergoing acid-catalysed polycondensation.

2. A process for the curing of binder systems which contain at least one component which is capable of undergoing acid-catalysed polycondensation, which comprises adding to these systems an effective quantity of at least one compound of the formula I, wherein the curing is carried out by heating or by combined irradiation and heating.

3. A process according to claim 2, which comprises adding from 0.1 to 20% by weight, preferably from 1 to 10% by weight, of compound(s) of the formula I.

4. A binder system which contains at least one component which is capable of undergoing acid-catalysed polycondensation, which system contains at least one compound of the formula I.

5. A binder system according to claim 4, which additionally contains components which can be polymerized by a free-radical mechanism.

6. A binder system according to claim 4 or 5, which contains from 0.1 to 20% by weight, preferably from 1 to 10% by weight, of compound(s) of the formula I.

**Revendications**

1. Utilisation de composés de formule I

$R^1$-$SO_2$-$SO_2$-$R^2$     I

dans laquelle $R^1$ et $R^2$ peuvent être identiques ou différents et représentent des restes alkyle, cycloalkyle, aryle, aralkyle ou hétéroaryle ayant jusqu'à 12 atomes de carbone, éventuellement substitués une ou plusieurs fois par des restes halogène, cyano, nitro, alkyle, alcoxy, alkylthio, mono- ou dialkylamino, alcanoyle, acyloxy, acylamido, alcoxycarbonyle, alkylaminocarbonyle, alkylsulfoxy, alkylsulfonyle, aryloxy, arylthio, arylsulfoxy, arylsulfonyle, ayant tous jusqu'à 6 atomes de carbone, comme catalyseurs acides latents, pouvant être activés par voie thermique ou par l'action combinée d'une exposition à un rayonnement et d'un chauffage, dans des systèmes de liants qui contiennent au moins un constituant susceptible de subir une polycondensation catalysée par un acide.

10

2. Procédé de durcissement de systèmes de liants qui contiennent au moins un constituant susceptible de subir une polycondensation catalysée par un acide, caractérisé en ce qu'on leur ajoute une quantité efficace d'au moins un composé de formule I, caractérisé en ce que l'on effectue le durcissement par chauffage ou par une exposition à un rayonnement et un chauffage combinés.

3. Procédé selon la revendication 2, caractérisé en ce que l'on ajoute 0,1 à 20 % en masse, de préférence 1 à 10 % en masse de composé(s) de formule I.

4. Systèmes de liants contenant au moins un constituant susceptible de subir une polycondensation catalysée par un acide, caractérisés en ce qu'ils contiennent au moins un composé de formule I.

5. Systèmes de liants selon la revendication 4, caractérisés en ce qu'ils contiennent en outre des constituants polymérisables par voie radicalaire.

6. Systèmes de liants selon la revendication 4 ou 5, caractérisés en ce qu'ils contiennent 0,1 à 20 % en masse, de préférence 1 à 10 % en masse de composé(s) de formule I.